(19) Europäisches Patentamt
European Patent Office
Office européen des brevets

(11) **EP 1 786 083 A1**

(12) **EUROPEAN PATENT APPLICATION**

(43) Date of publication:
**16.05.2007 Bulletin 2007/20**

(51) Int Cl.:
*H02H 7/04* (2006.01)     *G01N 33/28* (2006.01)
*G05B 23/02* (2006.01)

(21) Application number: 05380250.0

(22) Date of filing: **15.11.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **Union Fenosa Distribucion, S.A.**
**28033 Madrid (ES)**

(72) Inventors:
 • **Burgos Diaz, Juan Carlos**
  **28911 Leganes (Madrid) (ES)**
 • **Garcia de Burgos, Belen**
  **28911 Leganes (Madrid) (ES)**
 • **Alonso Rodriguez, Angel**
  **28006 Madrid (ES)**

 • **Poza Gonzalez, Francisco**
  **Lagoas-Marcosende, 9**
  **36310 Vigo (ES)**
 • **Siguenza Rodriguez, Cesar Augusto**
  **32003 Ourense (ES)**
 • **Bellon Garriga, Oren**
  **28045 Madrid (ES)**
 • **Mariño Espiñeira, Perfecto**
  **Lagoas-Marcosende, 9,**
  **36310 Vigo (ES)**

(74) Representative: **Carpintero Lopez, Francisco**
  **Herrero & Asociados, S.L.**
  **Alcalá 35**
  **28014 Madrid (ES)**

(54)    **Method and system for monitoring power transformers**

(57)    The present invention relates to a method and a system of monitoring power transformers, intended to detect incipient failures in a transformer. For this purpose, only sensors external to the transformer are used, or sensors that can be installed without needing to untank the transformer. The detection of the incipient failures is carried out based on mathematical models of behaviour, so that for the identification of the fault conditions a set of measured variables is compared, with some adaptive threshold values for each variable calculated from the operating conditions of the transformer. The mathematical models comprise a thermal model, a vibration model and a model of moisture in the oil.

FIG.1

**Description**

## OBJECT OF THE INVENTION

The present invention relates to a method and a system for monitoring power transformers, intended to detect incipient failures in a transformer. For this purpose, only sensors external to the transformer are used, or sensors that can be installed without needing to untank the transformer.

The detection of the incipient failures is carried out based on mathematical models of behaviour, so that for the identification of the failure conditions a set of measured variables is compared with some adaptive threshold values for each variable calculated from the operating conditions of the transformer.

The mathematical models comprise a thermal model, a vibration model and a model of moisture in the oil.

## BACKGROUND OF THE INVENTION

Different types of monitoring systems are known, according to how the diagnosis of the state of the transformer is made, and what criteria are used for emitting alarms. The monitoring systems can be classified into systems based on thresholds, and systems based on behaviour models.

In the systems of the first type, for the emission of alarms it is checked if the values of the variables monitored in the transformer are within certain preset acceptable limits, and in the event of this not being the case, an alarm is produced. The establishing of these thresholds is extremely complicated, since on one hand they must be sufficiently high so that false alarms do not occur and, on the other hand they must be sufficiently low so that they are able to detect the faults when these are still in an incipient stage. In addition, the threshold values of the magnitudes are not invariable, but depend rather on the working conditions of the transformer.

In the systems of monitoring based on models the use of fixed thresholds is replaced by the use of adaptive thresholds. The acceptable values of the magnitudes are being constantly determined as a function of the working conditions of the transformer. For the calculation of the thresholds use is made of behaviour models. The models calculate the value of a variable; this variable is also measured and, by means of the comparison of the two values, it is possible to determine if any failure has taken place in the transformer.

The systems of this type are more reliable for the detection of anomalies, since by taking into account the operating conditions of the transformer, they produce a smaller number of false alarms, and are able to detect faults that are not manifested by an excessive value of the variables measured.

In addition, in recent years, systems have been developed which base their diagnosis on techniques of artificial intelligence, such as neural networks, expert systems or systems based on fuzzy logic, which take into account the overall working conditions of the transformer without the need for a theoretical knowledge of the physical phenomena which they are analysing for the emission of alarms.

The use of models for monitoring transformers was proposed for the first time by researchers of the MIT, namely W. H. Hagman, T. H. Crowley, R. D. Tabors, and F. C. Schweppes. "An adaptive transformer monitoring system", in the Proceedings of the International Symposium for Demonstrations of Expert System Applications to the Power Industry, Montreal, Quebec, Canada, 7-12 May 1989. The system proposed in this publication incorporated five models. Some of these models, for their use, required the measurement of internal variables of the transformer. The models incorporated were: two temperature models (one of their own development, and the other based on the IEEE Standard C.57.91-1995 "IEEE Guide for loading mineral-oil-immersed transformers", 1995, which include equations for the calculation of the temperature of the upper part of the winding and for the calculation of the temperature of the hottest point in the winding, a vibration model of the transformer windings, a model of gases dissolved in the oil and a model of moisture in the oil.

Subsequently the definitive version of the system only incorporated 2 models: A thermal model, which calculates the temperature of the upper layer of the oil and a model of gases dissolved in the oil (which predicts the gases dissolved in the oil, comparing the prediction with the reading of a gas sensor and thereby allowing electric discharges and thermal defects to be detected in the transformer). This system has been installed in three transformers of the Boston Edison electricity utility since 1995.

The Doble Engineering company has developed and marketed a monitoring system which could perform the monitoring of transformers including the under-load tap changers and the terminal bushings, and also carries out the monitoring of switches. This system based its diagnosis on comparison with preset thresholds and also incorporates behaviour models. The variables monitored in the transformer are: temperatures of the upper layer and the lower layer of the oil, gases dissolved in the oil and moisture in the oil. Phase voltages and currents, and the state of the pumps and the fans are also measured.

This system also incorporates two thermal models, one of them for the calculation of the temperature of the hottest point, with which the loss of life of the insulation is evaluated caused by determined working conditions, and a second model for calculating the temperature of the upper layer of the oil. The analysis of the moisture is carried out by means of an expert system which alerts to dangerous conditions in which an excessive amount of water is detected in the oil.

The Siemens company has developed and markets a system which bases its identification of the failure condition on the comparison of the values of the measured variables with preset thresholds. This system allows a choice between a basic version which includes the measurement of a few variables (the temperatures of the upper and lower part of the oil, the ambient temperature, the concentration of hydrogen in the oil, the voltages and currents in a single phase, the position of the tap changer, and the leakage current of the terminal bushings) and other more complete versions, in which variables are measured like the moisture in the oil, the speed of the oil in the cooling circuit, the operating hours of the pumps and fans, currents and voltages in the three phases, etc.

The ABB company has also developed and markets a system for monitoring transformers. This system requires the measurement of the oil temperatures in the upper and lower part of the tank, the ambient temperature, the gas content in the Buchholz relay, the leakage current, the load current, the moisture in the oil, the concentration of gases dissolved in the oil, the state of the pumps and of the fans, the position of the tap changer and the temperature in the tap changer. For the detection of the failure condition, it incorporates an expert system based on neural networks and fuzzy logic.

The General Electric company has developed and markets its monitoring system, in which the variables measured are the content of gases dissolved in the oil, the moisture in the oil, the temperatures of the upper and lower part of the oil, the ambient temperature, the load current, the temperature of the hottest point, the state of the cooling system, measurements in the terminal bushings (partial discharges and measuring the voltage surges that reach the transformer), harmonics, level of oil and gases in the Buchholz relay. It also has a system of monitoring the under-load tap changer. The system uses models for emitting alarms, and so incorporates a temperature model, an aging model of the solid insulation, a bubble formation model and a model of moisture in the paper.

## DESCRIPTION OF THE INVENTION

The present invention is included in the monitoring systems based on the use of behaviour models, that is, for the identification of the failure conditions, a set of measured variables is compared with threshold values for each one of these variables. These threshold values are not fixed values, but instead they are calculated from the overall operating conditions of the transformer. By making use of adaptive thresholds, it is possible to detect faults that do not give rise to an abnormal value in a variable.

Although for fault detection in a transformer the use of models is more appropriate than the use of fixed thresholds, the fact that certain variables can reach high values has a harmful effect on the life of a transformer. Thus for example a high temperature or moisture content accelerates the aging of the insulation of the transformer. For this reason the invention combines the use of behaviour models with the use of fixed thresholds which alert to harmful or dangerous operating conditions in the transformer.

The behaviour models calculate the value of certain output variables from input variables which are measured by the sensors installed in the transformer. In some cases, to use the readings of the sensors as inputs to the models it is necessary to subject them to a certain processing. In turn, the output variable is also measured, this measured value being constantly compared with the calculated value. From this comparison the resulting difference or remainder is obtained in each operation.

If the transformer is in good condition, there should be great similarity between the measured and calculated values of the output variable at all times and therefore a low value of the remainder. On the other hand, if a failure occurs in the transformer, the predictions of the model will differ substantially from the measured values.

The remainders obtained in each operation of the model, are constantly compared with the maximum value established as acceptable for said remainders. Should the remainder exceed the acceptable maximum value, a signal will be emitted which makes the diagnosis module intervene which will carry an appraisal of the failure.

The invention comprises at least three behaviour models: a Thermal Model, a Vibration Model, and a Model of Moisture in the Oil, each intended to detect failures of a different type. All the models are based only on variables which can be measured without the need to install sensors inside the transformer.

The models have a number of parameters which it is necessary to calculate before beginning to use them. By changing the value of the parameters the models can be used in transformers of very different characteristics (geometry of windings and/or core, rating, oil mass, state of the oil and of the solid insulation, etc.).

The parameters of the models will be adjusted, applying a least squares algorithm to a data set measured in the transformer.

To take into account the change in the characteristics of the transformer associated with aging, the parameters of the models have to be readjusted periodically. An excessive rate of variation of parameters alerts to excessively rapid aging in the transformer.

For control of the system and method of the invention, a software application is available for the purpose of carrying out the adjustments of the models, running the models, and handling the information from which the emission of alarms is obtained. Its main characteristics are briefly described below.

- Adjustment of the models: The application can carry out adjustments in the models both in automatic mode (with a frequency established by the user to take into account the aging of the transformer) and in manual mode (it being the user that decides when to make the adjustment and with what data it should be carried out).

- Running the models: The application allows the models to be run in automatic mode at a frequency which can be chosen by the user or in manual mode. It also allows the user to decide with what parameters it is desired to run the models.

- Emission of alarms: The system is capable of transmitting the alarms that occur via e-mail to the party responsible for the system. The system emits alarms for: high remainder when running a model, high value of a variable measured, excessive rate of change in the parameters, excessive rise in the value of certain variables.

- Consulting historical records: The application allows the user to consult historical records on the evolution of the variables monitored in the transformer or on the results from running the models.

- Communication with the database: the application communicates with the database taking from it all the data necessary to carry out the aforementioned functions and recording in it the results obtained (results from the models, values of the parameters, alarms).

1. - Thermal Model.

One of the aspects of the invention relates to the creation of a model of thermal behaviour, the object of which is to detect problems of a thermal type in the transformer which result in abnormal heating, as well as faults in the cooling system (malfunctioning of pumps, blocking of radiators, etc.).

The thermal model has the temperature of the upper layer of the oil as the output variable, and as input variables for the calculation of the temperature of the upper part of the oil, it takes the load level, the ambient temperature, and the position (running or shut down) of the pumps and/or the fans.

The actual value of the temperature of the upper layer of oil can be measured in the well of the thermal imaging relay of the transformer.

The thermal model takes into account the transmission of heat between the different parts of the transformer: windings, solid insulation, oil and ambient air. The characteristics of the material media mentioned are very different, for which reason the model has several time constants. The proposed model contemplates two thermal transients which are governed by different time constants. The first represents the transient of the heat transmission from the windings to the oil which surrounds them when increasing (or decreasing) the load level, and the second is the oil heating transient.

The differential equation that constitutes the nucleus of the thermal model is:

$$C_1 R_1 C_2 R_2 \frac{d^2 \theta_{cs}}{dt^2} + \left( C_1 R_1 + C_2 R_2 + C_1 R_2 \right) \frac{d\theta_{cs}}{dt} - C_1 R_1 \frac{d\theta_{amb}}{dt} = \Delta \theta_{cs,u} - \theta_{cs} + \theta_{amb}$$

where $C_1$, $C_2$, $R_1$ and $R_2$ are constants, $\theta_{cs}$ is the temperature of the upper layer of the oil, $\theta_{amb}$ is the ambient temperature and $\Delta \theta_{cs,u}$ is the heating of the upper layer of the oil in steady state operation.

2.- Vibration model.

Another aspect of the invention relates to a vibration model the objective of which is to detect changes in the geometry of the transformer, especially deformations in the windings. For this purpose, the model determines the vibrations of the transformer tank which correspond to the operating conditions at any given moment. These vibrations are measured by means of accelerometers installed in the tank.

For the calculation of the tank vibration, the model takes into account the forces which give rise to vibrations inside the transformer (vibrations of the core and vibrations of the windings), as well as the composition of these vibrations and their transmission to the tank. The treatment of all the vibrations is carried out in the frequency domain.

The input variables to the model are the temperature measured in the upper layer of the oil, the input currents to the transformer and the voltages applied to the transformer.

The equation that constitutes the nucleus of the model is

$$v_{cuba,f} = (\alpha + \beta\theta_{cs})i_f^2 + (\gamma + \delta\dot{\theta}_{cs})u_f^2$$

where $\theta_{cs}$ is the temperature of the transformer in the upper layer of the oil.

This equation for a particular case would be:

$$v_{cuba,100} = (\alpha + \beta\theta_{cs})i_{50}^2 + (\gamma + \delta\dot{\theta}_{cs})u_{50}^2$$

where $\alpha$, $\beta$, $\gamma$ and $\delta$ are constants, $\theta_{cs}$ is the temperature of the upper layer of the oil, $u_{50}$ and $i_{50}$ are the harmonics of 50 Hz of the voltage and current of whatever phase and $V_{cuba,100}$ is the harmonic of 100 Hz of the vibration in the tank measured in the post of that winding in which the voltage and current are measured. In this sense, there are variants of the cooling system with three accelerometers (and therefore with three thermal models, one per phase) and variants with a single accelerometer. All the aforementioned variables are complex.

The vibrations produced by the oil circulation pumps and by the fans affect the vibrations in the tank, for this reason, in the case of transformers which have several pumps or fans that are connected or disconnected independently of each other, there will be as many models as there are cooling combinations. The models for different types of cooling only differ from each other in the values of their parameters. Therefore, to use the model for different cooling modes it will be necessary to perform an independent adjustment of parameters for each one of them based on data taken in the transformer when the latter is working with each cooling mode.

3. - Model of moisture in the oil

Another aspect of the invention relates to a Model of Moisture the objective of which is to detect faults that give rise to an additional ingress of water in the transformer, such as failures in the water-tightness of the tank, the silica gel desiccator being in poor state or a rapid aging of the paper. For this purpose, the Model determines the moisture in the transformer oil.

The Model incorporates a steady state operation submodel which calculates the water content of the insulating paper and of the oil when equilibrium is reached in the process of absorption or desorption of water from the paper to the oil or vice versa. The Model also incorporates another transient operation submodel, which allows the water content in the oil to be constantly calculated although the equilibrium has not been reached between the water in the paper and that in the oil. The model takes into account the additional ingress of water that is produced because of the aging of the paper. For this purpose it calculates the aging of the transformer during a determined period of operation. The calculation of the aging is carried out using the equations given by the IEC document "Loading Guide for Oil-Immersed Power Transformers, IEC-354 1991-09, 1991". For this calculation the temperature of the hottest point in the transformer must be used, which, in turn, is calculated as indicated in the aforesaid Loading Guide based on the load level with which the transformer is working.

The steady state operation submodel makes use of the Oomen moisture equilibrium curves in paper oil systems. The steady state operation submodel makes use of the temperature obtained by means of the previously described thermal model.

The transient operation submodel consists of three equations: the outgoing transient of the water from the paper to the oil, the diffusion transient of the water into the oil and the response transient of the sensor. The second of the equations mentioned depends on the type of circulation of the oil (natural or forced).

In a transformer, there is always a certain amount of water remaining from the manufacturing stage which fundamentally is absorbed in the insulating paper. In addition the water content increases during the life of the transformer, because the aging of the cellulose gives rise to the formation of water molecules.

Due to the great difference in affinity for water of the paper and of the oil, most of the water of the transformer is to be found in the paper. This great difference in affinity for water is revealed in the units in which the moisture is measured in the two media, since the water content of the paper is expressed in % (total weight of the water / weight of the paper without oil) whilst the water in the oil is expressed in parts per million (micrograms of water/grams of oil).

It has been found that the proportion existing between the water content of the paper and of the oil depends on the temperature. When the temperature of the transformer increases, part of the water accumulated in the paper passes to the oil. When the temperature of the transformer is reduced, this water returns slowly from the oil to the paper. The oil is highly hydrophobic, but the solubility of water therein increases noticeably with temperature. The oil is able to absorb a greater amount of water from the paper while the transformer remains hot. The water in the oil is almost always in solution. It can also appear strongly bound to the oil molecules, especially in deteriorated oil.

When the moisture in the oil exceeds the saturation value, water is formed in the free state, precipitated from the oil in suspension or in drops. The saturation of the oil can happen when, after a period of operation at high temperature in which the transfer of a significant amount of water has taken place from the paper into the oil, the temperature of the transformer falls sharply, for example by disconnecting the transformer. Under these conditions, the solubility of the oil would diminish rapidly and the water would begin to return into the paper. This return is much slower than the decrease in solubility for which reason under these conditions the saturation value could be exceeded.

The equilibrium between the water content of the paper and the oil has been extensively studied by several authors, who have established curves that represent the content of water in the paper versus the content of water in the oil at different temperatures and which allow the value of one of these variables to be determined starting from the other two. In practice this equilibrium is not reached in an immediate manner. According to the literature the time taken in establishing the equilibrium lies between a few hours and several days depending on the temperature at which the transformer is and also on whether the process is of transmission of water from the paper to the oil or of absorption of water by the paper. In addition, the temperature in a transformer does not remain constant for long periods of time, since continually there are variations of the load level and of the ambient temperature.

From the foregoing, to model the moisture in a continuous manner it is necessary to have equations which calculate the moisture in the oil of the transformer both in steady state operation and outside it, that is in transient operation.

3.1. - Steady state operation submodel. The steady state operation submodel calculates the concentration of water in the oil that would be reached in equilibrium (that is, when the absorption or desorption transients of water by the paper have concluded) at a certain temperature. The submodel has the moisture in the paper and the temperature as inputs.

The moisture in the paper is calculated from the moisture measured in the oil in periods in which the steady state of moisture in the oil has been reached. The submodel considers that the paper is an "infinite water source", that is, the processes of absorption and desorption do not alter the water content of the paper, which in this way only varies due to the water ingress caused by aging. This approximation is justified because the content of water in the oil, a few ppm, is very much less than the water content of the paper, % by weight. Therefore, in the steady state operation submodel, it is considered that the moisture in the paper is constant except for cases where there are water ingresses due to aging.

For each temperature, and taking into account the moisture in the paper, the moisture in the oil will be calculated in steady state operation using the equilibrium tables. It is considered that the curves which most reliably predict the equilibrium between the paper and the oil are those developed by Oommen.

In the present invention curves have been developed that cover a range of temperatures and moisture contents in the water and in the oil more broadly than according to the procedure described by Oommen, which cover a temperature range from 20 to 100˚ C, a range of moisture in the oil of between 0 and 900 ppm and a range of moisture in the paper of between 1 and 17% by weight.

The exchange of moisture between the paper and the oil takes place on the whole surface of the winding, whereby the final concentration of water in the oil depends on the temperature that is reached in the paper and in the surrounding oil over the whole winding. For this reason the temperature that must be taken as input for the model, is the mean temperature of the winding. This temperature will be calculated, in an approximate manner, as the mean of the temperature measured in the well and of the temperature measured in the lower part of the oil $\theta_{ci}$ according to the following equation.

$$\theta_{med} = \frac{\theta_{cs} + \theta_{ci}}{2} = \frac{\theta_{cs} + \theta_{hum}}{2} \quad (1)$$

To measure the temperature in the lower part of the oil advantage can be taken of the moisture sensor employed, which measures the temperature of the oil at the point in which it is installed.

Based on the mentioned input variables (mean temperature of the winding and moisture in the paper), the steady state operation submodel provides the equilibrium moisture of the oil (in ppm) using for this purpose the curves developed in the present invention.

3.2. - Transient operation submodel.

As has already been stated, the migration of the water between the paper and the oil is a slow process for which reason, in the event that the temperature is kept constant, the moisture equilibrium can take several hours to be reached. Besides the foregoing, in general the load level with which a transformer works, varies with time and the outside temperature changes from one hour of the day to another, whereby the equilibrium can never be reached completely. For these reasons, to use the model of moisture in the monitoring of transformers it is not sufficient to have a steady state operation model, instead it is necessary that the model take into account the transient operation that occurs until the equilibrium is reached.

In transient operation several time constants are involved, corresponding to the different physical processes that are taking place. In this sense, it is necessary to break down the transient operation into three different transients, which correspond to the outgoing transient of the water from the paper to the oil, to the diffusion transient of the water into the oil and to the response transient of the moisture sensor employed.

The transient corresponding to the diffusion of the water into the oil from the windings to the area of the transformer in which the sensor is installed is very different depending on whether the oil circulation pump is running or not. For this reason, when establishing the calculation algorithm of the model, it is necessary to treat the cases of natural cooling and forced cooling separately.

3.2.a Transient operation submodel for the case of Forced Cooling

The transient operation submodel has to consider the different transients that arise from the temperature changing and an exchange of water beginning between the paper and the oil, until a new equilibrium is reached.

a1) Outgoing transient of water from the paper to the oil.

The water needs a certain time to be released from the paper into the oil. It is proposed to apply Fick's second law to the problem, which is the manner of treating mass transfer problems. This equation, in its unidimensional version is expressed as follows:

$$\frac{\partial C}{\partial t} = \frac{\partial}{\partial x} D \frac{\partial C}{\partial x} \quad (2)$$

Where C(x,t) is the concentration of water at each point x and at each moment in time t, and D is the diffusion coefficient, which depends on the concentration and on the temperature according to equation 3.

$$D(C,T) = D_0 e^{kC + E_a (1/T_0 - 1/T)} \quad (3)$$

It is clear that this equation is not easily applicable in a continuous manner. However, under certain conditions, an analogy can be established between the mass transfer and the heat transfer, formulating the problem with an equation of type 4.

$$\tau_{pap} \frac{dH_{ac}}{dt} + H_{ac} = H_{ac-rp} \quad (4)$$

where $H_{ac}$ is the water content of the oil, in the area proximate to the winding at a given moment in time, and $H_{ac-rp}$ is the water in the oil which would be reached in steady state operation, according to the equilibrium curves developed in the present invention, for the mean temperature of the winding at that same moment in time.

The foregoing equation gives satisfactory results when the temperature is constant (and therefore so too is the value of $H_{ac-rp}$); however, when the temperature changes the value of $H_{ac-rp}$ is not constant in the integration period, and results closer to reality are obtained using an intermediate moisture value between the initial value and final value of the integration period. The moisture in steady state operation at any moment in time inside the integration interval can be expressed as 5.

$$H_{ac-rp} = H_{ac-rp} + \Delta t \frac{dH_{ac-rp}}{dt} \quad (5)$$

where $\Delta t$ is a shorter time interval than the integration step (in practice the value of $\Delta t$ will be obtained during the process of identifying parameters of the model). Thus, the water content in the oil in the proximity of the winding will be given by the differential equation 6:

$$\tau_{pap} \frac{dH_{ac}}{dt} + H_{ac} = H_{ac-rp} + \Delta t \frac{dH_{ac-rp}}{dt} \quad (6)$$

a2) Transient of water diffusion in the oil.

The moisture sensor does not measure the concentration of water in the proximity of the windings, but at the point where the sensor is installed, which is usually in a valve on the lower part of the tank.

When the transformer works with the oil circulation pump running, it can be considered that the distribution of water in the oil is homogeneous in the whole volume of the transformer. This assumption is justified by the fact that the oil circulation is a much faster phenomenon than the natural diffusion of the water in the oil.

For this reason, in the event that the oil circulation pump is in service (OFAN operation), it can be considered that the water concentration in the oil in the area of the sensor, is the same as that in the proximity of the winding (equation 7).

$$H_{sens}(t) = H_{ac}(t) \quad (7)$$

where $H_{sens}$ is the moisture in the oil in the area of the sensor.

a3) Measurement transient of the sensor

The moisture sensor has a certain response time, inherent in its operating principle, which corresponds to the time it would take for an equilibrium to be reached between the oil of the area in which it is installed, and the polymer film of the sensor. The manufacturer of the sensor, in his technical specifications, includes the curves that give the response of the sensor when a decrease or an increase takes place in the water content of the oil in which it is immersed. The curves were obtained experimentally in oil at 25° C. The response time of the sensor decreases for higher temperatures. The response of the sensor can be modelled according to a first order equation with a time constant $\tau_{sens}$.

$$\tau_{sens} \frac{dH_m}{dt} + H_m = H_{sens} \quad (8)$$

where $H_m$ is the moisture measured by the sensor at each instant, and $H_{sens}$ is the moisture in the oil in the area of the sensor at each moment.

Substituting equation 6 in 8, one obtains:

$$\tau_{pap}\tau_{sens}\frac{d^2 H_m}{dt^2}+(\tau_{pap-ac}+\tau_{sens})\frac{dH_m}{dt}+H_m=H_{ac-rp}+\tau_{hrp}\Delta t\frac{dH_{ac-rp}}{dt} \quad (9)$$

This equation 9 constitutes the transient operation submodel when the transformer is working with the oil circulation pump running.

b) Transient operation submodel for the case of Natural Cooling

As in the previous case, this submodel takes into account three transients:

- Outgoing transients of water from the paper to the oil.
  The migration of the water between the paper and the oil (or vice versa), is independent of whether the oil circulation pump is running or not. Thus, this transient will be modelled in the same way as for forced cooling by means of the equation 6.
- Transients of water diffusion into the oil.
  When the pump is stopped, the diffusion of water into the oil until reaching the sensor, is a slow process that has to be taken into account.
  Although this diffusion process is complex and depends on the temperature, it will be modelled in a simplified form by means of the first order equation 10 with time constant $\tau_{ac}$, ignoring the dependence which this time constant has on the temperature.

$$\tau_{ac}\frac{dH_{sens}}{dt}+H_{sens}=H_{ac} \quad (10)$$

where $H_{sens}$ is the water content of the oil, in the area proximate to the sensor at a moment in time and $H_{ac}$ is the water content of the oil, in the area proximate to the winding at that moment.

- Measurement transient of the sensor.
  This transient is independent of whether the oil circulation pump is running or not. Thus, this transient will be modelled in the same way as for forced cooling by means of the equation 8.

Substituting the equation 8 in 10, the result is:

$$\tau_{ac}\tau_{sens}\frac{d^2 H_m}{dt^2}+(\tau_{ac}+\tau_{sens})\frac{dH_m}{dt}+H_m=H_{ac}+\tau_{hrp}\Delta t\frac{dH_{ac-rp}}{dt} \quad (11)$$

and substituting this equation 11 in 6, the result is:

$$\tau_{pap}\tau_{ac}\tau_{sens}\frac{d^3 H_m}{dt^3}+(\tau_{pap}\tau_{ac}+\tau_{pap}\tau_{sens}+\tau_{ac}\tau_{sens})\frac{d^2 H_m}{dt^2}$$

$$+(\tau_{ac}+\tau_{sens}+\tau_{pap})\frac{dH_m}{dt}+H_m=H_{ac-rp}+\tau_{hrp}\Delta t\frac{dH_{ac-rp}}{dt} \quad (12)$$

This equation 12 constitutes the transient operation submodel when the transformer works with the oil circulation pump shut down.

3.3. - Increase of the water content of the paper caused by aging

Numerous authors have studied the production of water caused by the aging of the insulating paper constituted basically by cellulose. Heinrichs presents data on the increase of moisture produced on aging Kraft paper thermally in an oil bath, during an experiment performed to study the formation of bubbles at high temperatures. The experiment consisted in heating a capsule with paper (previously vacuum-dried) and oil to a temperature of 90° C for 48 hours. During the test the capsule was subjected to brief periods of heating (of about 2h in duration) in which the temperature was increased up to 130, 145, 150 and 160° C. During the experiment, the production of bubbles was studied by observation with microscope. The analysis of the water content before and after aging, revealed an increase of the water concentration in the oil of 3 ppm to 23.9 ppm.

There are two mechanisms which cause the degradation of the cellulose, hydrolysis, which produces furane compounds and oxidation, which produces water, CO and $CO_2$. Murphy presents a study on the kinetics of the oxidation reactions that give rise to the thermal degradation of the cellulose. In this study he analysed experimentally the concentrations of water, CO and $CO_2$ resulting from the degradation of the cellulose at temperatures of between 100° C and 250° C, observing that the production of water augmented sharply above 135° C. Murphy explained this increment in water production by the presence of two chemical reactions of different activation energy which take place simultaneously. The first of them, which is the slower, is that which degrades the main structure of the cellulose and the second, which is the quicker, is that which degrades its secondary structure. The degradation reaction of the main structure is activated on exceeding 135°C.

The Model of Moisture, considers that when certain temperature levels are surpassed an additional water production of takes place, whereby the water content of the paper, which until then was considered constant, increases. In view of the results presented by Murphy, the threshold temperature has been set at 135° C in the hottest point in the winding. Although it is true that the exchange of moisture depends on the mean temperature of the winding (when carrying out this exchange over all its surface), for calculating the production of water by aging, it is more appropriate to use the temperature of the hottest point in the winding, since it will be in this area where there will be greatest production of water.

When the temperature threshold is reached, an amount of water will be produced proportional to the aging of the paper. the relative aging in a time period $\Delta_t$, in which the temperature of the hottest point reached is $\theta_{hs}$, is determined from the equation of the standard IEC 354:

$$E_a = 2^{\frac{\theta_{hs}-98}{6}} \Delta t \quad (13)$$

where $E_a$ is the relative aging rate with respect to normal aging (which is that which would occur at a temperature of 98° C). The value of $\theta_{hs}$, can be calculated using the equations given by the standard IEC-354 in section 2.4. (14 for the case of a transformer with natural cooling, and 15 for a transformer with forced cooling).

$$\theta_{hs} = \theta_{amb} + \Delta\theta_{or}(\frac{1+RK^2}{1+R})^x + Hg_r K^y \quad (14)$$

$$\theta_{hs} = \theta_{amb} + \Delta\theta_{br}(\frac{1+RK^2}{1+R})^x + 2(\Delta\theta_{imr} - \Delta\theta_{br}) + Hg_r K^y \quad (15)$$

The meaning of the symbols of the equations 14 and 15 is to be found in table 1.

| Variable | Meaning |
| --- | --- |
| $\theta_{hs}$ | Temperature of the hottest point in the winding |

| | |
|---|---|
| $\theta_{amb}$ | Ambient temperature |
| K | Load level $I/I_r$ |
| $\Delta\theta_{or}$ | Heating of the upper layer of the oil with respect to the ambient level that would be reached in steady state operation for the assigned load level |
| R | Ratio between the losses in copper and the losses in iron |
| x | Exponent of the oil (0.8 for ONAN cooling and 1 for OFAN cooling) |
| $H^{gr}$ | Difference between the temperature of the upper layer of the oil and the temperature of the hottest point |
| and | Exponent of the winding (1.6 for ONAN and OFAN cooling) |
| $\Delta\theta_{br}$ | Heating of the lower part of the oil with respect to the ambient level for the assigned load |
| $\Delta\theta_{imr}$ | Mean heating of the oil for the assigned load |

In the periods of time in which the temperature threshold is surpassed, the water content of the paper will be calculated by means of 16.

$$H_{pap}(t) = H_{pap}(t-1) + k_{env}E_a(t) \quad (16)$$

To obtain the constant $k_{env}$ of the foregoing equation an adjustment has to be made of the model in periods of time in which the threshold temperature has been surpassed.

A system for the monitoring of power transformers according to the invention, is intended for the detection of incipient failures in a transformer and comprises: a data acquisition subsystem which obtains the measurement of external variables in the transformer coming from sensors located in the transformer, a data storage subsystem, means for producing a model of thermal behaviour to obtain a value of the temperature of the upper layer of the transformer oil, calculated from at least the temperature of the upper part of the oil, the load level of the transformer, the ambient temperature, and the position (running or shut down) of the pumps and/or the fans. The system also comprises means for the production of a model of behaviour of moisture in the oil of the transformer for obtaining a calculated value of moisture in the oil, which comprises a transient operation submodel and a steady state operation submodel based on the temperature provided by the thermal model. The system also includes means to measure each actual value of each model and compare this measured value with the calculated value and so obtain a remainder or difference, and means to constantly compare said difference with an established maximum value and produce an action when that difference exceeds said maximum value.

## DESCRIPTION OF THE DRAWINGS

To complete the description that is being made and with the object of assisting in a better understanding of the characteristics of the invention, in accordance with a preferred example of practical embodiment thereof, the same is accompanied, as an integral part of said description, with a set of drawings wherein by way of illustration and not restrictively, the following has been represented:

Figure 1. - It represents in a schematic form the monitoring and diagnosis system object of the present invention.

Figure 2. - It represents a power transformer in perspective, and the location therein where, in a preferred embodiment, various sensors and pre-conditioning devices have been installed.

Figure 3. - It represents schematically the process for obtaining the remainder based on the behaviour models.

Figure 4. - It represents an electric schematic equivalent to the thermal model of the invention for two time constants.

Figure 5. - It represents a graph of the magnetostriction of the iron in a transformer as a function of the magnetic field according to R.M. Bozorth. Ferromagnetism in IEEE Press 1993.

Figure 6. - It represents a graph of the magnetostriction of the iron in a transformer as a function of the flux density according to R.M. Bozorth. Ferromagnetism in IEEE Press 1993 and amendment.

Figure 7. - It represents the temperature equilibrium curves developed between the paper and the oil.

PREFERRED EMBODIMENT OF THE INVENTION

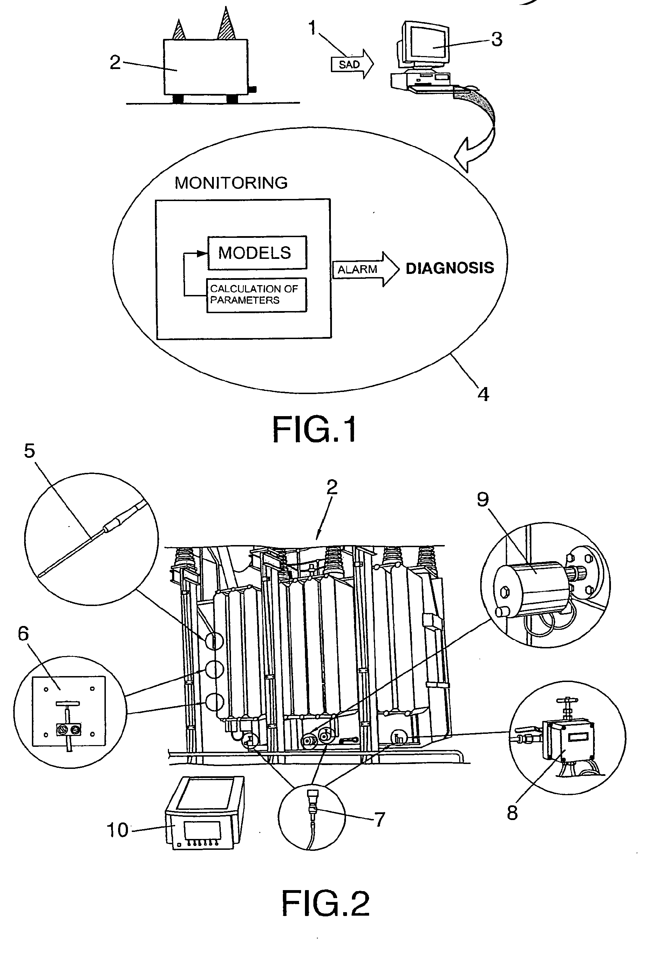

The method of monitoring disclosed is implemented in a system based on an industrial computer, and it has been represented schematically in figure 1, where it is observed that the system consists of three subsystems, a Data Acquisition subsystem (1) of a power transformer (2), a Data Storage subsystem (3) and a Monitoring subsystem based on Models (4).

In a preferred embodiment the three subsystems are implemented in the same industrial computer. However said subsystems are developed so that they are capable of operating as independently as possible and the interfaces through which they interact have been very clearly defined. Thus these same subsystems can be used in a distributed environment where each of them is implemented in an independent computer provided a communications connection is present between them. As has already been mentioned the three subsystems reside in the same computer and for this reason they share the hardware and software elements.

The Data Acquisition subsystem (1) corresponds to the measurement of variables in the Transformer, both those that constitute the input information of the models and those utilized for obtaining the remainders of the same. For its operation, the system requires the measurement only of variables external to the transformer, or of internal variables that can be measured using externally installed sensors (moisture in the oil, temperature of the oil, etc.). This has its repercussion when developing the models, since it requires that all the variables, both input and output, which intervene therein, are measurable with this type of sensor. The hardware used in this subsystem includes a number of sensors for the acquisition of the physical phenomenon it is desired to measure, pre-conditioning units, a conditioning unit and a data acquisition card.

The sensors which have been used are shown in table 1. In it, the variables are indicated that have to be measured, as well as the type of sensor employed for each of these measurements.

| Table 1: Measurements necessary for implementing the models | | |
|---|---|---|
| Magnitude | Sensor | Location |
| Temperature of the upper layer of the oil | PT100 surface sensor (6) | Stuck to the transformer tank. Top centre of the side face |
| Temperature of the lower layer of the oil | PT100 surface sensor (6) | Stuck to the transformer tank. Bottom centre of the side face |
| Ambient temperature | Atmospheric PT100 sensor (5) | At less than 2 m from the |
| | | transformer, at mid-height |
| HT and LT Currents | Toroidal current transformer + Card with Hall probes | Housed in the system cabinet |
| HT and LT Voltages | Card with Hall probes | Housed in the system cabinet |
| Vibrations in the tank | Piezoelectric accelerometer with output under load (7) | Stuck on the lower base of the tank |
| Moisture in the oil | Capacitive hygrometer (8) | Sample taking valve of the oil |
| Gas sensor (9) | Hydran type or similar | Sample taking valve of the oil |
| State of pumps and fans | | |
| State of the supply switch to the transformer | | |

Figure 2 shows the location in the transformer of some of the sensors and pre-conditioning units. In the part on the left the appearance is shown of the PT100 probes used, the probe (5) is that which is used for measuring the ambient temperature and it is located in a receptacle placed on the concrete wall beside the transformer (2). The probe (6) is stuck on an aluminium support and this in turn is stuck on the lower and upper part of the transformer tank. The accelerometers (7) can be seen in the lower part, stuck on the lower part of the transformer tank under each of its phases. The output signals of these accelerometers are amplified with the amplifier unit (10) located inside the ventilation cabinet of the transformer, although in figure 2 it has been represented beside the accelerometers (7).

Lastly the HALL cards, not shown, are located in the system cabinet.

The system incorporates diverse pre-conditioning units to appropriately treat the signals obtained by the sensors. In short there is a unit (10) which serves to transform the charge output of the piezoelectric accelerometers (7) used into a voltage output. A commercial capacitive hygrometer (8) serves to deliver two current signals 4-20 mA. One corresponds to a resistance of the PT100 type which measures temperature and the other corresponds to the moisture measurement of the capacitive hygrometer (8). Both sensors (PT100 and hygrometer) are located in the same sheath.

A commercial unit (9) delivers a 4-20 mA current signal proportional to the gas concentration measurement of the sensor.

The Hall cards are several printed circuit boards which include commercial Hall sensors, designed to carry out the measurement of the instantaneous values of the transformer currents and voltages. The signals applied to the input of the HALL sensors are taken from the voltage and current transformers which carry out the measurement of said variables in the transformer.

The conditioning of the signals delivered by the different sensors and pre-conditioning units, is carried out by conventional techniques.

The system has a software application whose mission is to carry out the data acquisition, processing and storage, using the hardware mentioned above.

It is an application in which there are several processes running concurrently (multi-thread). On one hand there is the user interface which allows all the parameters to be configured relative to the data storage (DSN, user and password), to the data acquisition (acquisition period, sampling rates, number of points, what sensors are to be acquired, etc.) and it also allows the different signals measured to be displayed.

Another process serves to perform the acquisition of the analogue signals. From all the analogue sensors (at the moment 17 in total), 4K samples are acquired, at a sampling rate of 4KS/s. The interval between captures can be configured by means of the user interface and at the moment it is 5 minutes. There are analogue sensors of which it is of interest to know the frequency spectrum (vibrations, voltages and currents) for this purpose the Fourier transform is calculated and the harmonics of 50Hz are stored up to a frequency of 800Hz (these are termed rapidly evolving variables). There are other variables of slower evolution of which the rms value is obtained (voltages and currents) and their mean value (temperature, moisture and gas concentrations).

A third process has the job of carrying out the acquisition of the 9 actual digital variables, which indicate the state of the voltage-free contacts corresponding to the H.T. switch, pumps and fans.

The last process is that which serves to store all the measurements carried out in an Oracle database.

The mission of the Data Storage subsystem (3), is to carry out the storage of the data captured by the Data Acquisition subsystem (1) and to present them in an appropriate way to the Monitoring Subsystem based on Models (4). It has been developed fundamentally using the commercial application of the Oracle 9i Database. In it, the data structures have been defined that are necessary for both the data acquisition system and for the model system.

It is necessary to point out that two libraries of functions have also been developed in C++ language. One of them is used by the data acquisition system to store data in the Database and employs direct calls to the OCI library of Oracle instead of using the ODBC standard. In this way it is achieved that the Data Acquisition System stores the data in the Database approximately 25 times faster. The other library developed uses ODBC for communication with the Database but it presents the monitoring application with a more user-friendly interface.

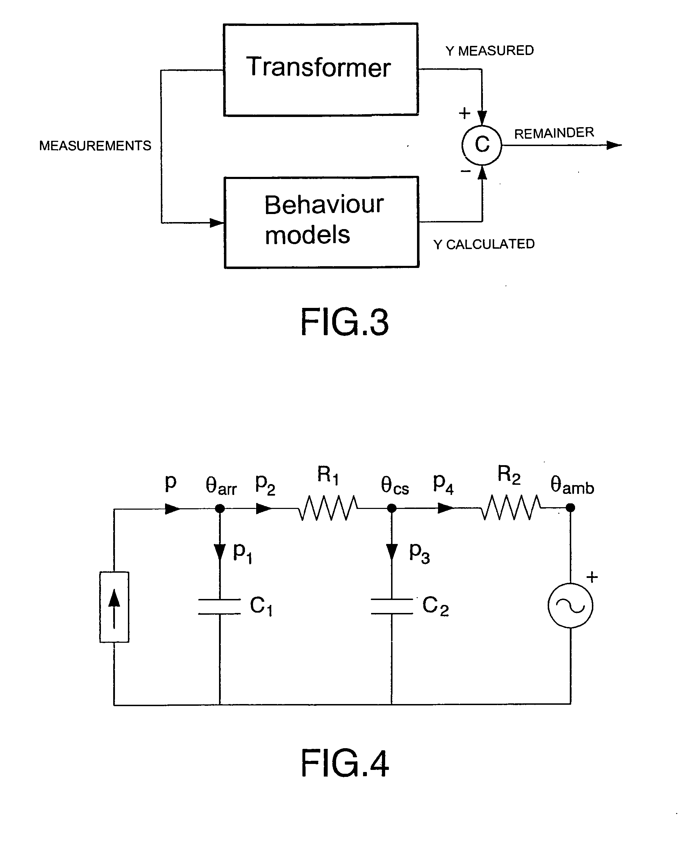

The invention comprises a monitoring subsystem based on behaviour models, which calculate the value of certain output variables from input variables which are measured by the sensors installed in the transformer. In some cases, as mentioned above, to use the sensor readings as inputs to the models it is necessary to subject them to a certain processing. At the same time, the output variable is also measured, this measured value being constantly compared with the calculated value. From this comparison the resulting remainder is obtained in each operation as illustrated in figure 3.

1.- Thermal model.

As was mentioned above, the differential equation which constitutes the nucleus of the model is

$$C_1 R_1 C_2 R_2 \frac{d^2\theta_{cs}}{dt^2} + \left(C_1 R_1 + C_2 R_2 + C_1 R_2\right)\frac{d\theta_{cs}}{dt} - C_1 R_1 \frac{d\theta_{amb}}{dt} = \Delta\theta_{cs,u} - \theta_{cs} + \theta_{amb}$$

where $C_1$, $C_2$, $R_1$ and $R_2$ are constants, $\theta_{cs}$ is the temperature of the upper layer of the oil, $\theta_{amb}$ is the ambient temperature and $\Delta\theta_{cs,u}$ is the heating of the upper layer of the oil in steady state operation.

For its installation in a computer, the foregoing equation has to be made discrete. In addition, a distinction has to be made between the case of natural cooling and the case of forced cooling. Thus the discrete equations are

- For the case of cooling with natural circulation of oil.

$$\theta_{cs}(t) = k_{tn1}\theta_{amb}(t) + k_{tn2}\theta_{amb}(t-1) + k_{tn3}I(t)^{1,6} + k_{tn4}\theta_{cs}(t-1) + k_{tn5}\theta_{cs}(t-2) + k_{tn6}$$

where (t), (t-1) and (t-2) refer to the moment in time when the measurement is taken.

- For the case of cooling with forced circulation of oil

$$\theta_{cs}(t) = k_{tf1}\theta_{amb}(t) + k_{tf2}\theta_{amb}(t-1) + k_{tf3}I(t)^{2} + k_{tf4}\theta_{cs}(t-1) + k_{tf5}\theta_{cs}(t-2) + k_{tf6}$$

In the case of transformers which have several pumps or fans that are connected or disconnected independently of each other, there will be as many models as there are cooling combinations. All these models will respond to the foregoing equation but they must be adjusted independently starting from data measured with the transformer working in each cooling mode.

To obtain the temperature of the transformer, it is necessary to take into account the transmission of heat between the different parts thereof: windings, solid insulation, oil and surrounding air. The proposed model considers two thermal transients which are governed by different time constants. The first one represents the transient of heat transmission from the windings to the oil which surrounds them when increasing (or reducing) the load level, and the second is the heating transient of the oil.

An electrical analogy can be made of this heat transmission problem, resulting in the electric circuit of figure 4, in which the heat contribution due to the power of losses is represented as a current source, the heat capacity of the oil and of the insulating paper as capacitors, and the thermal conduction in the paper and in the oil as the flow of a current through resistances.

The capacitance of the equivalent capacitors is calculated by means of the equation 12.

$$C = mc_e \quad (12)$$

where m is the mass and $c_e$ is the specific heat of the element considered. For its part,

$$R_t = \frac{1}{K_t S} \quad (13)$$

where S is the heat exchange surface and $K_t$ is the constant of convection between the elements considered. By analysing the circuit of the figure, the following set of equations is obtained:

$$p_1 = C_1 \frac{d\theta_{arr}}{dt} \quad (14)$$

$$\theta_{arr} - \theta_{cs} = p_2 R_1 \quad (15)$$

$$P_3 = C_2 \frac{d\theta_{cs}}{dt} \quad (16)$$

$$p = p_1 + p_2 \quad (17)$$

$$p_2 = p_3 + p_4 \quad (18)$$

$$\theta_{cs} - \theta_{amb} = p_4 R_2 \quad (19)$$

where $p$ is the power in losses, $\theta_{arr}$ is the temperature of the winding and $\theta_{cs}$ is the temperature of the upper layer of the oil.

By eliminating the variables that are unknown and not of interest from the foregoing set of equations, the equation 20 is obtained, which relates the temperature of the upper layer of the oil with the input variables to the system (ambient temperature, and losses of active power).

$$C_1 C_2 R_1 \frac{d^2\theta_{cs}}{dt^2} + (C_2 + \frac{C_1 R_1}{R_2} + C_1)\frac{d\theta_{cs}}{dt} = p + \frac{C_1 R_1}{R_2}\frac{d\theta_{amb}}{dt} - \frac{1}{R_2}\theta_{cs} + \frac{1}{R_2}\theta_{amb} \quad (20)$$

So that only time constants and adimensional constants appear in the differential equation of the model, in the equation 20 it is necessary to replace the losses of active power as a function of the temperature of the upper layer in steady state operation.

When for a certain load level, the steady state condition of temperatures has been reached, and assuming that the ambient temperature remains constant, the equation 20 is reduced to 21.

$$pdt = \frac{1}{R_2} \Delta\theta_{cs,u} dt \quad (21)$$

where $\Delta\theta_{cs,u}$ is the heating which would be attained in the upper part of the oil in steady state operation for a certain load level, and is calculated as in the foregoing models according to the equation 22.

$$\Delta\theta_{cs,u} = \Delta\theta_{cs,r}(\frac{R(\frac{I}{I_r})^2 + 1}{R + 1})^n \quad (22)$$

Substituting 21 in the equation 20, the result is:

$$C_1 R_1 C_2 R_2 \frac{d^2 \theta_{cs}}{dt^2} + (C_1 R_1 + C_2 R_2 + C_1 R_2) \frac{d\theta_{cs}}{dt} - \tag{23}$$

$$-C_1 R_1 \frac{d\theta_{amb}}{dt} = \Delta\theta_{cs,u} - \theta_{cs} + \theta_{amb}$$

To obtain the algorithm for calculating the thermal model with two time constants, the differential equation 23 is made discrete by using the first and second order formula of Euler [7].

$$\frac{dx}{dt} \approx \frac{x(t) - x(t-1)}{\Delta t} \tag{24}$$

$$\frac{d^2 x}{dt^2} \approx \frac{x(t) - 2x(t-1) + x(t-2)}{\Delta t} \tag{25}$$

where $t$, $t$-1 and $t$ - 2 represent the actual moment and the two preceding, and $\Delta t$ is the integration step.

With these relations, the equation 23 now becomes:

$$\theta_{cs}(t) = \frac{C_1 R_1 + \Delta t}{C_1 R_1 C_2 R_2 + C_1 R_1 + C_2 R_2 + C_1 R_2 + \Delta t} \theta_{amb}(t) -$$

$$- \frac{C_1 R_1}{C_1 R_1 C_2 R_2 + C_1 R_1 + C_2 R_2 + C_1 R_2 + \Delta t} \theta_{amb}(t-1) +$$

$$+ \Delta\theta_{cs,r} \frac{\Delta t}{C_1 R_1 C_2 R_2 + C_1 R_1 + C_2 R_2 + C_1 R_2 + \Delta t} \left(\frac{R(\frac{I(t)}{I_r})^2 + 1}{R + 1}\right)^n +$$

$$+ \frac{2C_1 R_1 C_2 R_2 + C_1 R_1 + C_2 R_2 + C_1 R_2}{C_1 R_1 C_2 R_2 + C1 R_1 + C_2 R_2 + C_1 R_2 + \Delta t} \theta_{cs}(t-1) -$$

$$- \frac{C_1 R_1 C_2 R_2}{C_1 R_1 C_2 R_2 + C_1 R_1 + C_2 R_2 + C_1 R_2 + \Delta t} \theta_{cs}(t-2) \tag{26}$$

For the resolution of this equation, it is also necessary to distinguish between the case of forced cooling, and natural cooling, due to the presence of the third term.

1.1 Forced cooling

As is already known, for the case of forced cooling n takes the value 1. Substituting in the equation 26 and grouping constants, the result is:

$$\theta_{cs}(t) = k_{f1}\theta_{amb}(t) + k_{f2}\theta_{amb}(t-1) + k_{f3}I(t)^2 +$$

$$+k_{f4}\theta_{cs}(t-1) + k_{f5}\theta_{cs}(t-2) + k_{f6} \quad (27)$$

where:

$$k_{f1} = \frac{C_1R_1 + \Delta t}{C_1R_1C_2R_2 + C_1R_1 + C_2R_2 + C_1R_2 + \Delta t} \quad (28)$$

$$k_{f2} = -\frac{C_1R_1}{C_1R_1C_2R_2 + C_1R_1 + C_2R_2 + C_1R_2 + \Delta t} \quad (29)$$

$$k_{f3} = \Delta\theta_{cs,r} \frac{\Delta t}{C_1R_1C_2R_2 + C_1R_1 + C_2R_2 + C_1R_2 + \Delta t} \frac{\frac{R}{I_r^2} + 1}{R+1} \quad (30)$$

$$k_{f4} = \frac{2C_1R_1C_2R_2 + C1R_1 + C_2R_2 + C_1R_2}{C_1R_1C_2R_2 + C_1R_1 + C_2R_2 + C_1R_2 + \Delta t} \quad (31)$$

$$k_{f5} = -\frac{C_1R_1C_2R_2}{C_1R_1C_2R_2 + C_1R_1 + C_2R_2 + C_1R_2 + \Delta t} \quad (32)$$

$$k_{f6} = \Delta\theta_{cs,r} \frac{\Delta t}{C_1R_1C_2R_2 + C_1R_1 + C_2R_2 + C_1R_2 + \Delta t} \frac{1}{R+1} \quad (33)$$

1.2 Natural cooling

For the case of natural cooling, n takes the value 0.8 which, on substituting in 26, gives rise to a non-linear equation. The calculation of parameters in a non-linear equation is not straightforward and does not always give good results, for which reason three possible solutions have been tried to deal with the problem.

1.2.1 Approximation for high load levels

With high loads, it is possible to approximate the equation 26 to a linear equation since as $R>>1$, it can also be assumed $\left(\frac{I}{I_r}\right)^2 \cdot R \gg 1$. The load level $I/I_r$, for which this approximation results valid depends naturally on the value of R, but it can be considered acceptable for values that are not less than 0.7 approximately.

By introducing the approximation in 26 and grouping constants, the result is the equation 35

$$\theta_{cs}(t) = k_{nke1}\theta_{amb}(t) + k_{nke2}\theta_{amb}(t-1) + k_{nke3}I(t)^{1.6} + \quad (34)$$

$$+k_{nke4}\theta_{cs}(t-1) + k_{nke5}\theta_{cs}(t-2)$$

where

$$k_{nke1} = \frac{C_1R_1 + \Delta t}{C_1R_1C_2R_2 + C1R_1 + C_2R_2 + C_1R_2 + \Delta t} \quad (35)$$

$$k_{nke2} = -\frac{C_1R_1}{C_1R_1C_2R_2 + C1R_1 + C_2R_2 + C_1R_2 + \Delta t} \quad (36)$$

$$k_{nke3} = \frac{\Delta\theta_{cs,r}}{I_r^{1.6}} \frac{\Delta t}{C_1R_1C_2R_2 + C1R_1 + C_2R_2 + C_1R_2 + \Delta t} \quad (37)$$

$$k_{nke4} = \frac{2C_1R_1C_2R_2 + C1R_1 + C_2R_2 + C_1R_2}{C_1R_1C_2R_2 + C1R_1 + C_2R_2 + C_1R_2 + \Delta t} \quad (38)$$

$$k_{nke5} = -\frac{C_1R_1C_2R_2}{C_1R_1C_2R_2 + C1R_1 + C_2R_2 + C_1R_2 + \Delta t} \quad (39)$$

1.2.2 Approximation by means of a semi-physical model

A more precise approximation than the previous one consists in adding an independent term to the equation 35. Thus, the resulting model would be:

$$\theta_{cs}(t) = k_{nsf1}\theta_{amb}(t) + k_{nsf2}\theta_{amb}(t-1) + k_{nsf3}I(t)^{1.6}$$

$$+k_{nsf4}\theta_{cs}(t-1) + k_{nsf5}\theta_{cs}(t-2) + k_{nsf6} \quad (40)$$

1.2.3 Non-linear model

A third possibility is to use the equation 26 directly, and to identify the parameters, use iterative methods which allow an adjustment of the non-linear model to be carried out. In this case, by grouping constants in the equation 26, the result is:

$$\theta_{cs}(t) = k_{nnl1}\theta_{amb}(t) + k_{nnl2}\theta(t-1) + (k_{nnl3}I^2(t) + k_{nnl4})^{0.8}$$

$$+k_{nnl5}\theta_{cs}(t-1) + k_{nnl6}\theta_{cs}(t-2) \quad (41)$$

where:

$$k_{nnl1} = \frac{C_1R_1 + \Delta t}{C_1R_1C_2R_2 + C1R_1 + C_2R_2 + C_1R_2 + \Delta t} \quad (42)$$

$$k_{nnl2} = -\frac{C_1R_1}{C_1R_1C_2R_2 + C1R_1 + C_2R_2 + C_1R_2 + \Delta t} \quad (43)$$

$$k_{nnl3} = \Delta\theta_{cs,r}\frac{\Delta t}{C_1R_1C_2R_2 + C1R_1 + C_2R_2 + C_1R_2 + \Delta t}\frac{R}{I_r^2(R+1)} \quad (44)$$

$$k_{nnl4} = \Delta\theta_{cs,r}\frac{\Delta t}{C_1R_1C_2R_2 + C1R_1 + C_2R_2 + C_1R_2 + \Delta t}\frac{1}{R+1} \quad (45)$$

$$k_{nnl5} = \frac{2C_1R_1C_2R_2 + C1R_1 + C_2R_2 + C_1R_2}{C_1R_1C_2R_2 + C1R_1 + C_2R_2 + C_1R_2 + \Delta t} \quad (46)$$

$$k_{nnl6} = -\frac{C_1R_1C_2R_2}{C_1R_1C_2R_2 + C1R_1 + C_2R_2 + C_1R_2 + \Delta t} \quad (47)$$

On comparing the foregoing three possibilities experimentally the best results were found when using the semi-physical model, and therefore that is the preferred approximation in the monitoring system.

2. - Vibration model

For calculating the vibrations of the tank, the Model has to take into account how the vibrations are produced in the different points of the transformer, how they are superimposed and how they are transmitted until reaching the tank.
The vibrations are produced by forces of different types which appear in the core and in the windings during the operation of the transformer.

2.1. - Forces in the windings.

The vibrations, in the windings, are due to the electrodynamic forces which are produced when the current that flows through a winding interacts with the leakage flux that links it. These forces have a component in the axial direction, and a component in the radial direction. When a current flows through a winding it creates a magnetic field in all the medium that surrounds it. In any case, the leakage field at any point in the window of the transformer can be taken as linearly dependent on the current (equation 1).

$$B_d = ki \quad (1)$$

A conductor immersed in a magnetic field through which a current flows, experiences a force of value 2

$$\vec{F} = i\vec{l} \times \vec{B} \quad (2)$$

Given the irregular distribution of the field spread over each winding of the transformer, the radial and axial forces in a winding vary over the winding. From the preceding equations 2 and 1 it can be deduced that the force to which a certain turn is subjected is proportional to the square of the current in a winding of the transformer. The axial forces on a conductor are due to the radial component of the lines of flux density which form the leakage field. This leakage field is created by the rest of the windings of the transformer and also by the turns of the winding to which the conductor belongs. Because the flux density created by a conductor at a point depends on the distance, the greatest contribution to the axial forces comes from the turns of the winding itself.
The axial force in the windings is produced when the current that flows through them interacts with the radial component of the leakage field. By virtue of the equations 2 and 1, equation 3 is obtained.

$$F_{ax,arr} \propto i^2 \quad (3)$$

The radial forces to which a conductor is subjected, are due to the axial component of the leakage field. In the same way as for the axial forces, by taking into account 2 and 1, equation 4 is obtained.

$$F_{rad,arr} \propto i^2 \quad (4)$$

In the simple case of a transformer with two windings, a force appears which tends to compress the internal winding and expand the external winding, since the currents in the windings of a given phase have opposing directions.

2.2.- Forces in the core.

The vibrations of the core are due to two types of force, the magnetostriction forces, and the magnetic forces.
Magnetostriction is a phenomenon through which ferromagnetic materials suffers a change in their dimensions, of an order of magnitude of a few parts per million, on being subjected to a magnetic field. This change in the dimensions, is mainly produced in the direction of application of the magnetic field (longitudinal magnetostriction, $\lambda_l$). During the magnetisation, a certain transversal magnetostriction $\lambda_t$ also appears, which produces an elongation of the order of half that produced by longitudinal magnetostriction, and of the opposite sign. Lastly, the volumetric magnetostriction, is the change in the volume of the material which appears for high values of applied magnetic field, and it is of a lower order of magnitude than that of the other two.

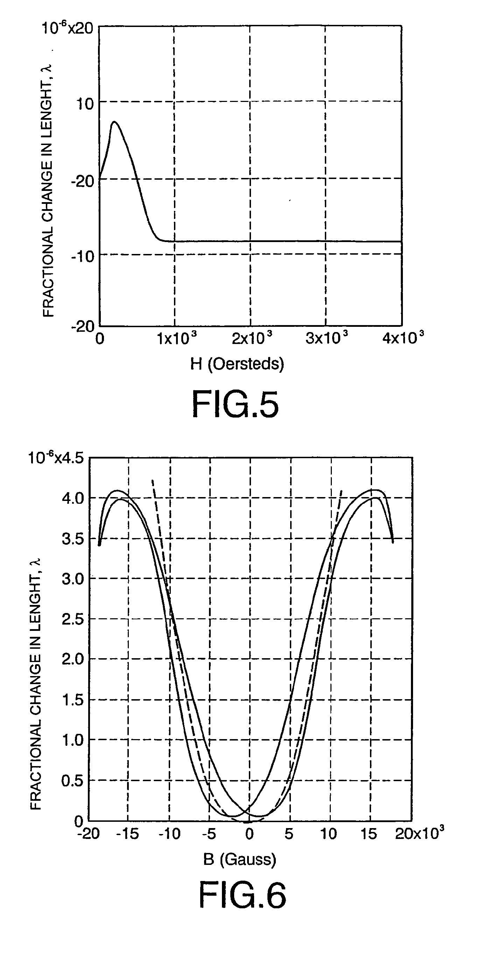

In figure 5 the relative change of the length is shown as a function of the magnetic field applied in the case of iron; the curve of the figure varies slightly from one iron alloy to another. For reduced values of applied magnetic field, an increase in the length of the material takes place; the variation in the length is small, since most of the magnetostriction takes place during the rotation of the magnetic domains. As from a certain field value, the material begins to reduce its length, finally reaching a smaller size than that which it had before magnetization. When the magnetic field is proximate to that of saturation, the decrease in length tends to a limiting value.

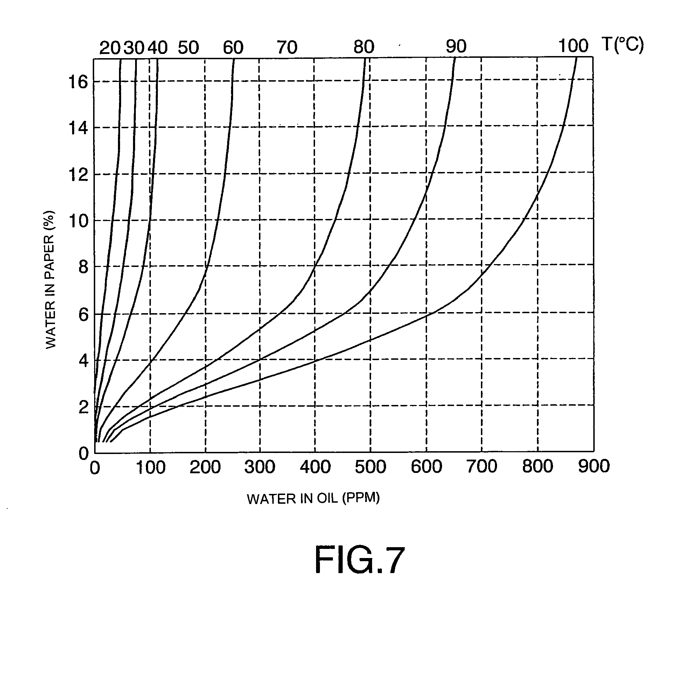

Based on the magnetization curve of the material and on figure 6, figure 7 is obtained which shows the relationship between variation in length (in %) and the magnetic flux density. It can be observed how the curve presents hysteresis. To model the magnetostriction forces, the hysteresis effect shown in figure 6 will be ignored, substituting the real curves (continuous line in figure 6) with an idealized curve (dashed line in figure 6). The mathematical expression of said idealized curve approximates a parabola, it being possible in this way to establish a linear relationship between the elongation and the square of the flux density.

$$\lambda = k_1 B^2 \quad (5)$$

Taking into account the relationship existing between the applied voltage and the flux density according to the expression 6.

$$U = 4.44\, fNB_s \quad (6)$$

and assuming the elongation is proportional to the force, the following expression is reached:

$$F_{nucl} \propto U^2 \quad (7)$$

The magnetostriction also depends on the temperature. The relationship between the elongation and the temperature is not linear; however, to establish a simplified model, this dependence will be taken as linear.

$$F = U^2 (k_1 + k_2 \theta) \quad (8)$$

In the transformer most of the lines of flux are confined to the plane of the core. For this reason, the fundamental components of the magnetostriction forces are in the plane of the core and they are:

- The longitudinal magnetostriction which is produced in the direction of the legs and of the yokes, and its effect is to vary the length of the strips, so that for reduced values of the field the length is increased and for high values of the field it is diminished.
- The transverse magnetostriction is produced in the direction perpendicular to the legs and the yokes in the plane of the core. It has the opposite effect to the longitudinal magnetostriction and is of half the value.

The fundamental component of the magnetostriction force has a frequency double that of the supply voltage (equation 8). However, other harmonics exist in the value of said force. In the first place this is due to the non-linearity of the magnetostriction phenomenon. In addition, if the core was a solid iron piece, the magnetostriction would only cause vibrations in the plane of the core. In practice, the core consists of stacked magnetic strips and the joints between legs and yokes are overlapping, under these circumstances an irregular distribution of the flux appears due to small variations of the air gap between the strips of the legs and those of the yokes and interlaminar flux in the joints. This is the origin of magnetostriction forces in planes perpendicular to that of the core. In addition, the strips have small irregularities that rub against each other when the core vibrates exciting other modes of vibration in the direction perpendicular to it.

Besides the magnetostriction forces, magnetic forces also appear in the core which are also due to the construction of the core in legs and yokes. These forces appear in the joints and between the adjacent strips due to the variation of the permeability.

2.3 -. Vibrations in the transformer

The forces analysed in the foregoing section give rise to vibrations in the different directions of the core and of the windings.

Simplifying the problem, the vibration of each element can be treated separately, and in each direction considering only the forces that appear on it in that direction. So it is possible to liken the problem to the analysis of the vibrations of a mass suspended by a spring, subjected to a harmonic force. To take into account the effect of the friction of the oil, a viscous friction term has been included.

Timoshenko has modelled this problem with the differential equation:

$$m\ddot{x} = -kx - c\dot{x} + Q\cos\omega t \quad (9)$$

where x is the displacement of the mass.

In our problem, m is the mass of the body which vibrates (core or windings), kx represents the restoring force of the element which tries to make this return to its initial position, $c\dot{x}$ is the resistive force which damps the vibrations due to the friction with the oil, and $Q\cos\omega t$ is the applied harmonic force (forces in the windings, or in the core).

By dividing 9 by m and introducing the notation 10, 11, 12 the result is the equation 13.

$$p^2 = \frac{k}{m} \quad (10)$$

$$2n = \frac{c}{m} \quad (11)$$

$$q = \frac{Q}{m} \quad (12)$$

$$\ddot{x} + 2n\dot{x} + p^2 x = q\cos\omega t \quad (13)$$

This differential equation has a particular solution that is given by 14

$$x_p = M\cos\omega t + N sen\omega t \quad (14)$$

where the constants N and M are given by 15 and 16.

$$M = \frac{q(p^2 - \omega^2)}{(p^2 - \omega^2)^2 + 4n^2\omega^2} \quad (15)$$

$$N = \frac{q(2n\omega)}{(p^2 - \omega^2)^2 + 4n^2\omega^2} \quad (16)$$

The general solution of the differential equation 13, is given by 17, and is obtained by adding to this particular solution the homogeneous solution, which represents the free response of the system.

$$x = e^{-nt}(C_1 \cos p_d t + C_2 \operatorname{sen} p_d t) + M\cos\omega t + N\operatorname{sen}\omega t \quad (17)$$

where

$$p_d = \sqrt{p^2 + n^2} \quad (18)$$

and $C_1$ and $C_2$ are constants which have to be determined from the initial conditions. The free response, is a harmonic and of frequency $p_d/2\pi$, which are the natural frequencies of the system. Due to the viscous friction term which has been included, the free response term is damped with a time constant $1/n$. The tied response represents the response of the system to the applied harmonic force. This vibration is at the same frequency as the force, and is maintained with time while the force continues to act.

Taking the second derivative in the equation 17, the expression for the acceleration is obtained (which is what we have taken as vibration) 19.

$$\ddot{x} = e^{-nt}((-C_1 p_d^2 - 2np_d C_2 + n^2 C_1)\cos p_d t + (-C_2 p_d^2 + 2np_d C_1$$
$$+ n^2 C_2)\operatorname{sen} p_d t) - M\omega^2\cos\omega t - N\omega^2\operatorname{sen}\omega t \quad (19)$$

The acceleration is composed by a free term (which will be extinguished after a certain time), and a forced term, which is a harmonic and at the same frequency as the applied force. Suppressing the free term, taking into account the expressions of N, M and q, and grouping constants, equation 20 is obtained wherein it can be seen that the forced vibration is a harmonic of the same frequency as the applied force, and proportional to its amplitude.

$$\ddot{x}_f = K_1 Q \cos(\omega t) + Q K_2 \operatorname{sen}(\omega t) \quad (20)$$

2.4.- Vibrations in the windings

According to that analysed in the section 2.1, the harmonic force that produces the forced vibrations in the windings in the axial direction is proportional to the square of the current. Moreover, the current can contain pertinent harmonics at frequencies which are odd multiples of 50 Hz, which are obtained by breaking it down into a Fourier series (equation 21).

$$i = \sum_f i_f cos(2\pi ft + \varphi_{u_{1,50}i_f}) \quad (21)$$

where $\varphi_{u50if}$ is the phase shift of the harmonic of frequency $f$ of the current taking as phase origin the harmonic of frequency 50 Hz of the voltage on the high voltage side. So the force in the windings in the axial direction will be 22 and will have its pertinent harmonics at frequencies which are a multiple of 100 Hz.

$$F_{ax,arr} \propto (\sum_f i_f cos(2\pi ft + \varphi_{u_{1,50}i_f}))^2 \quad (22)$$

And finally, taking the equation 20 into account, it results that the vibrations of the windings in the axial direction, will be constituted by a term which vanishes after a certain time and a harmonic term of frequencies which are multiples of 100 Hz, according to the expression 23.

$$vib_{ax,arr} \propto (\sum_f i_f cos(2\pi ft + \varphi_{u_{1,50}i_f}))^2 \quad (23)$$

In the same way, taking into account the expression of the force in the windings in the radial direction, the following equation is obtained:

$$vib_{rad,arr} \propto (\sum_f i_f cos(2\pi ft + \varphi_{u_{1,50}i_f}))^2 \quad (24)$$

2.5.- Vibrations in the core

According to that analysed in 2.2, the harmonic force which produces the forced vibrations in the core is proportional to the square of the voltage, and taking into account the expression of the voltage broken down into a Fourier series 25, the expression is found for the force as a function of the frequency, and to the expression for the vibrations in the core as a function of the frequency.

$$u = \sum_f u_f cos(2\pi ft + \varphi_{u_{1,50}u_f}) \quad (25)$$

$$F_{nucl} \propto (\sum_f u_f cos(2\pi ft + \varphi_{u_{1,50}u_f}))^2 \quad (26)$$

$$vib_{nucl} \propto (\sum_f u_f cos(2\pi ft + \varphi_{u_{1,50}u_f}))^2 \quad (27)$$

where $\varphi_{u1,50uf}$ is the phase shift between the harmonic at frequency f of the voltage, and the harmonic of 50 Hz of the voltage on the high voltage side.

The voltage applied to the transformer, practically only has the fundamental component of 50 Hz, whereby the core should vibrate at 100 Hz. In practice, due to the effect of irregularities in the strips, this is not so, as will be shown later when analysing the experimental results.

2.6.- Vibrations in the tank

The vibrations of the core and of the windings are superimposed, and they are transmitted to the tank through the oil and the supporting elements of the live part of the transformer. To establish the equation of the model, it has been assumed that the vibration in the tank in a certain direction is the sum of the vibration of the windings and that of the core, in that direction multiplied by different constants which model the transmission to the tank.

$$v_{cuba} = t_1 v_{arrollamiento} + t_2 v_{nucleo} \ (28)$$

where the terms $v_{cuba}$, $v_{arrollamiento}$, $v_{nucleo}$ have been given to the vibrations (accelerations) of the tank, the windings and the core respectively, and $t_1$ and $t_2$ to the transmission constants as a function of acceleration.

For reasons that will be examined later in the description of the model of moisture, the vibration in the tank has been considered as input variable of the model at the point in which there is greatest response from the axial vibration of the winding. So, using the equations 23,24,26 and 28 the vibration of the tank is modelled for each frequency according to the equation 29.

$$v_{cuba,f} = c_1 i_f^2 + c_2 u_f^2 \ (29)$$

For application to the model, the following considerations must be taken into account:

- The equation 29 has to be verified for each of the harmonics, for which reason one will work with the Fourier transforms of the variables.
- The equation 29 relates the complex magnitudes, and it must, therefore, be verified in the real part and in the imaginary part. The parameters of the equation are also complex numbers.

2.7. - Dependence of the vibrations on the temperature

Up to now only the effects of the magnitudes that physically originate the vibrations have been included in the model, that is, the current and the voltage. Besides these two magnitudes, the influence of the temperature in the vibrations must be taken into account. This influence has a twofold origin:

- Firstly, as was shown above, the magnetostriction, and therefore the vibration of the core, depend on the temperature.
- In addition on changing the temperature, the viscosity of the oil will also change. This change in the viscosity will make the viscous friction attenuating the vibrations change through rubbing with the oil, and moreover as the medium present between the biscuits of the windings is oil, it will change the restoring constant of the winding.
- Lastly, the variation of the temperature can cause expansions or compressions of certain structural elements of the transformer, whereby both the natural frequencies and the amplitude of the forced oscillations could be changed.

The three effects analysed influence the generation of the vibrations. The temperature also influences the transmission of the vibrations to the tank through the change in the viscosity of the oil. From the foregoing analysis, it is evident that the temperature should not be included in the model as an excitation of the system (that is, as an independent addendum), since if the transformer was de-energised, and underwent an abrupt variation in temperature, it would not experience any vibration. The dependence must be introduced as a variation in the parameters of the equation. So, including this aspect, the model equation would become:

$$v_{cuba,f} = (\alpha + \beta\theta_{cs})i_f^2 + (\gamma + \delta\theta_{cs})u_f^2 \quad (30)$$

where $\theta_{cs}$ is the temperature of the transformer in the upper layer of the oil.

It has been chosen to include the temperature at this point in the model, for being correlated with the temperature of the oil in the dependent areas and for being easily accessible.

3. - Model of moisture in the oil

To use the equations that relate the magnitudes of the physical process (17 and 12) in a monitoring system, it is necessary to make them discrete as explained below.

3.1. - Forced cooling

The equation of the transient operation submodel for the case of forced cooling is the equation 17 which is reproduced below.

$$\tau_{pap}\tau_{sens}\frac{d^2H_m}{dt^2} + (\tau_{pap} + \tau_{sens})\frac{dH_m}{dt} + H_m = H_{ac-rp} + \tau_{hrp}\Delta t \frac{dH_{ac-rp}}{dt} \quad (17)$$

To make this second order equation discrete, the following change of variable will be carried out:

$$z = \frac{dH_m}{dt} \quad (18)$$

thus, substituting 18 in the equation 17, the result is:

$$\tau_{pap}\tau_{sens}\frac{dz}{dt} + (\tau_{pap} + \tau_{sens})z + H_m = H_{ac-rp} + \tau_{hrp}\Delta t \frac{dH_{ac-rp}}{dt} \quad (19)$$

and applying the Euler approximation to the equations 18 and 19 the result is:

$$z(t) = \frac{H_m(t) - H_m(t-1)}{\Delta t} \quad (20)$$

$$\tau_{pap}\tau_{sens}\frac{z(t)-z(t-1)}{\Delta t}+(\tau_{pap}+\tau_{sens})z(t)+H_m(t)=$$

$$=H_{ac-rp}(t)+\tau_{hrp}\Delta t\frac{H_{ac-rp}(t)-H_{ac-rp}(t-1)}{\Delta t} \qquad (21)$$

ad substituting 20 in 21 the discrete equation as a function of $H_m$ is finally obtained.

$$H_m(t)(\frac{\tau_{pap}\tau_{sens}}{\Delta t^2}+\frac{\tau_{pap}+\tau_{sens}}{\Delta t}+1)+H_m(t-1)(-\frac{2\tau_{pap}\tau_{sens}}{\Delta t^2}-$$

$$-\frac{\tau_{pap}+\tau_{sens}}{\Delta t})+H_m(t-2)\frac{\tau_{pap}\tau_{sens}}{\Delta t^2}=H_{ac-rp}(t)+\tau_{hrp}\Delta t\frac{dH_{ac-rp}}{dt} \qquad (22)$$

Eliminating $H_m(t)$ from this equation, and grouping constants, the result is:

$$H_m(t)=k_{1hf}H_m(t-1)+k_{2hf}H_m(t-2)+k_{3hf}H_{ac-rp}(t)+k_{3hf}H_{ac-rp}(t-1) \qquad (23)$$

which is the algorithm of the model of moisture for the case of forced cooling. The constants of the model are:

$$k_{1hf}=\frac{2\tau_{pap}\tau_{sens}+\tau_{pap}\Delta t+\tau_{sens}\Delta t}{\tau_{pap}\tau_{sens}+\tau_{pap}\Delta t+\tau_{sens}\Delta t+\Delta t^2} \qquad (24)$$

$$k_{2hf}=-\frac{\tau_{pap}\tau_{sens}}{\tau_{pap}\tau_{sens}+\tau_{pap}\Delta t+\tau_{sens}\Delta t+\Delta t^2} \qquad (25)$$

$$k_{3hf}=\frac{\Delta t^2+\tau_{hrp}\Delta t\Delta t}{\tau_{pap}\tau_{sens}+\tau_{pap}\Delta t+\tau_{sens}\Delta t+\Delta t^2} \qquad (26)$$

$$k_{4hf}=-\frac{\tau_{hrp}\Delta t\Delta t}{\tau_{pap}\tau_{sens}+\tau_{pap}\Delta t+\tau_{sens}\Delta t+\Delta t^2} \qquad (27)$$

In the case of transformers that have several pumps which are connected or disconnected in a mutually independent manner, there will be as many models as there are cooling combinations. The different models with forced cooling would respond to the foregoing equation, but their parameters would have to be adjusted independently using data measured during periods in which the monitored transformer was working with each cooling mode.

3.2. - Natural cooling

The equation of the transient operation submodel is equation 12 which is reproduced below:

$$\tau_{pap}\tau_{ac}\tau_{sens}\frac{d^3H_m}{dt^3}+(\tau_{pap}\tau_{ac}+\tau_{pap}\tau_{sens}+\tau_{ac}\tau_{sens})\frac{d^2H_m}{dt^2}+$$

$$+(\tau_{ac}+\tau_{sens}+\tau_{pap})\frac{dH_m}{dt}+H_m=H_{ac-rp}+\tau_{hrp}\Delta t\frac{dH_{ac-rp}}{dt} \quad (28)$$

In like manner to that employed for making the equation discrete of the moisture submodel in transient operation for forced cooling, for making the third order equation 28 discrete, it is necessary to introduce two auxiliary variables z and x, defined as:

$$z=\frac{dH_m}{dt} \quad (29)$$

$$x=\frac{dz}{dt}=\frac{d^2H_m}{dt^2} \quad (30)$$

substituting 29 and 30 in the equation 28, the result is

$$\tau_{pap}\tau_{ac}\tau_{sens}\frac{dx}{dt}+(\tau_{pap}\tau_{ac}+\tau_{pap}\tau_{sens}+\tau_{ac}\tau_{sens})x+ \quad (31)$$

$$+(\tau_{ac}+\tau_{sens}+\tau_{pap})z+H_m=H_{ac-rp}+\tau_{hrp}\Delta t\frac{dH_{ac-rp}}{dt}$$

and applying the Euler approximation it becomes:

$$\tau_{pap}\tau_{ac}\tau_{sens}\frac{x(t)-x(t-1)}{\Delta t}+(\tau_{pap}\tau_{ac}+\tau_{pap}\tau_{sens}+\tau_{ac}\tau_{sens})x(t)+$$

$$+(\tau_{ac}+\tau_{sens}+\tau_{pap})z(t)+H_m(t)=H_{ac-rp}(t)+\tau_{hrp}\Delta t\frac{H_{ac-rp}(t)-H_{ac-rp}(t-1)}{\Delta t} \quad (32)$$

moreover, it is possible to apply the Euler approximation to 29 and to 30, whereby the following is obtained

$$z(t) = \frac{H_m(t) - H_m(t-1)}{\Delta t} \quad (33)$$

$$x(t) = \frac{z(t) - z(t-1)}{\Delta t} = \frac{H_m(t) - 2H_m(t-1) + H_m(t-2)}{\Delta t^2} \quad (34)$$

By substituting 33 and 34 in 32, and grouping constants, the discrete equation of the model 35 is obtained.

$$H_m(t) = k_{1hn} H_m(t-1) + k_{2hn} H_m(t-2) + k_{3hn} H_m(t-3) + \quad (35)$$
$$+ k_{4hn} H_{ac-rp}(t) + k_{5hn} H_{ac-rp}(t-1)$$

where (t), (t-1) and (t-2) refer to the moment in time in which the measurements are made, Hm is the moisture measured with the sensor, Hac-rp is the moisture in steady state operation.

In the light of this description and set of figures, an expert in the matter will be able to comprehend that the embodiments of the invention which have been described can be combined in multiple ways inside the object of the invention. The invention has been described according to some preferred embodiments of the same, but for an expert in the matter it will be evident that multiple variations can be introduced in said preferred embodiments without surpassing the object of the claimed invention.

**Claims**

1. Method of monitoring power transformers intended for the detection of incipient failures in a transformer **characterized in that** it comprises

   obtaining signals coming from sensors located on the exterior of the transformer,
   generating a model of thermal behaviour for obtaining an estimated value of the temperature in the upper layer of the transformer oil, calculated from at least the temperature of the upper part of the oil, the load level of the transformer, the ambient temperature, and the position (running or shut down) of the pumps and/or of the fans,
   generating a model of moisture in the oil of the transformer for obtaining an estimated value of moisture in the oil, which comprises a transient operation submodel and a steady state operation submodel based on the temperature provided by the thermal model,
   measuring the actual value of each model and comparing this measured value with the value calculated by the corresponding model, and obtaining the difference between values,
   comparing continually said difference with an established maximum value and producing an alarm when that difference exceeds said maximum value.

2. Method according to claim 1, **characterized in that** the thermal model comprises a first transient of heat transmission from the windings to the oil that surrounds them on increasing or decreasing the load level, and a second transient of the oil heating.

3. Method according to the claims 1 or 2, **characterized in that** the thermal model is defined by the equation

$$C_1 R_1 C_2 R_2 \frac{d^2\theta_{cs}}{dt^2} + \left(C_1 R_1 + C_2 R_2 + C_1 R_2\right)\frac{d\theta_{cs}}{dt} - C_1 R_1 \frac{d\theta_{amb}}{dt} = \Delta\theta_{cs,u} - \theta_{cs} + \theta_{amb}$$

where $C_1$, $C_2$, $R_1$ and $R_2$ are constants, $\theta_{cs}$ is the temperature of the upper layer of the oil, $\theta_{amb}$ is the ambient temperature and $\Delta \theta_{cs,u}$ is the heating of the upper layer of the oil in steady state operation.

4. Method according to claim 3 **characterized in that** the differential equation of the thermal model for the case of natural cooling is made discrete by means of an approximation to a semi-physical model.

5. Method according to any one of the previous claims **characterized in that** the transient operation submodel of the model of moisture in the oil consists of an outgoing transient of the water from the paper of the oil, a diffusion transient of the water into the oil and a response transient of the sensor.

6. Method according to claim 5 **characterized in that** the transient operation submodel when the transformer is working with the oil circulation pump running, is:

$$\tau_{pap}\tau_{sens}\frac{d^2 H_m}{dt^2} + (\tau_{pap-ac} + \tau_{sens})\frac{dH_m}{dt} + H_m = H_{ac-rp} + \tau_{hrp}\Delta t \frac{dH_{ac-rp}}{dt}$$

7. Method according to claim 5 **characterized in that** the transient operation submodel when the transformer is working with the oil circulation pump shut down, is:

$$\tau_{pap}\tau_{ac}\tau_{sens}\frac{d^3 H_m}{dt^3} + (\tau_{pap}\tau_{ac} + \tau_{pap}\tau_{sens} + \tau_{ac}\tau_{sens})\frac{d^2 H_m}{dt^2}$$

$$+(\tau_{ac} + \tau_{sens} + \tau_{pap})\frac{dH_m}{dt} + H_m = H_{ac-rp} + \tau_{hrp}\Delta t \frac{dH_{ac-rp}}{dt}$$

8. Method according to any one of the previous claims **characterized in that** it comprises producing a vibration model for obtaining a calculated value of the deformations of the windings from the temperature measured in the upper layer of the oil, the input currents to the transformer and the voltages applied to the transformer.

9. Method according to claim 8, **characterized in that** the vibration model is defined by the equation.

$$v_{cuba,f} = (\alpha + \beta\theta_{cs})i_f^2 + (\gamma + \delta\theta_{cs})u_f^2$$

where $\alpha$, $\beta$, $\gamma$ and $\delta$ are constants, $\theta_{cs}$ is the temperature of the upper layer of the oil, $u_f$ and $i_f$ are the harmonics of the voltage and of the current of any given phase and $V_{cuba,f}$ is the harmonic of the frequency f of the vibration in the tank measured in the leg of that winding in which the voltage and the current are measured.

10. System for the monitoring of power transformers intended for the detection of incipient failures in a transformer **characterized in that** it comprises

   a data acquisition subsystem which obtains the reading of external variables in the transformer from sensors located on the exterior of the transformer
   a data storage subsystem
   a monitoring subsystem based on models which comprises
   means for generating a model of thermal behaviour for obtaining an estimated value of the temperature of the upper layer of the transformer oil, calculated from at least the temperature of the upper part of the oil, the load level of the transformer, the ambient temperature, and the position (running or shut down) of the pumps and/or of the fans,
   means for generating a model of behaviour of moisture in the transformer oil for obtaining a calculated value of moisture of the oil, which comprises a transient operation submodel and a steady state operation submodel based on the temperature provided by the thermal model

means to measure each actual value of each model and to compare this measured value with the calculated value and obtaining a remainder or difference

means to constantly compare said difference with an established maximum value and to produce an alarm when said difference exceeds said maximum value.

11. System according to claim 10 **characterized in that** it comprises means to produce a vibration model for obtaining an estimated value of the deformations of the windings from the temperature measured in the upper layer of the oil, the input currents to the transformer and the voltages applied to the transformer.

FIG.1

FIG.2

EP 1 786 083 A1

FIG.3

FIG.4

FIG.5

FIG.6

EP 1 786 083 A1

FIG.7

35

European Patent
Office

**EUROPEAN SEARCH REPORT**

Application Number

EP 05 38 0250

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2002/161558 A1 (GEORGES BRUNO ET AL) 31 October 2002 (2002-10-31) * abstract * * paragraph [0007] * * paragraph [0017] - paragraph [0025] * * paragraph [0035] - paragraph [0036] * * paragraph [0205] - paragraph [0206] * * paragraph [0285] - paragraph [0313] * * paragraph [0391] * * claim 1; figures 1-3 * | 1,10 | H02H7/04 G01N33/28 G05B23/02 |
| A | KIRTLEY J L ET AL: "MONITORING THE HEALTH OF POWER TRANSFORMERS" IEEE COMPUTER APPLICATIONS IN POWER, IEEE INC. NEW YORK, US, vol. 9, no. 1, January 1996 (1996-01), pages 18-23, XP000550604 ISSN: 0895-0156 * the whole document * | 1,10 | |
| A | US 2004/159146 A1 (BELANGER MICHEL) 19 August 2004 (2004-08-19) * abstract * * paragraphs [0012], [0047] * * paragraph [0060] - paragraph [0095]; figures 1,2 * | 1,10 | TECHNICAL FIELDS SEARCHED (IPC) H02H G01N G05B |
| A | US 5 781 764 A (DEGENEFF ET AL) 14 July 1998 (1998-07-14) * column 1, line 54 - column 2, line 10 * | 1,10 | |
| A | US 2002/180611 A1 (WEEKES MARK ANTHONY ET AL) 5 December 2002 (2002-12-05) * paragraph [0009] - paragraph [0020] * | 1,10 | |

-/--

The present search report has been drawn up for all claims

| Place of search | Date of completion of the search | Examiner |
|---|---|---|
| The Hague | 4 April 2006 | Marti Almeda, R |

EPO FORM 1503 03.82 (P04C01)

**European Patent Office**

**EUROPEAN SEARCH REPORT**

Application Number

EP 05 38 0250

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 6 609 079 B1 (SEITLINGER WALTER) 19 August 2003 (2003-08-19) * column 2, line 17 - line 23 * * abstract; figure 1 * ----- | | |
| A | US 5 838 881 A (NELSON ET AL) 17 November 1998 (1998-11-17) ----- | | |

TECHNICAL FIELDS
SEARCHED      (IPC)

The present search report has been drawn up for all claims

| Place of search | Date of completion of the search | Examiner |
|---|---|---|
| The Hague | 4 April 2006 | Marti Almeda, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 05 38 0250

This annex lists the patent family members relating to the patent documents cited in the above-mentioned European search report.
The members are as contained in the European Patent Office EDP file on
The European Patent Office is in no way liable for these particulars which are merely given for the purpose of information.

04-04-2006

| Patent document cited in search report | | Publication date | Patent family member(s) | | Publication date |
|---|---|---|---|---|---|
| US 2002161558 | A1 | 31-10-2002 | NONE | | |
| US 2004159146 | A1 | 19-08-2004 | AU | 2003254649 A1 | 02-02-2004 |
| | | | WO | 2004008129 A2 | 22-01-2004 |
| | | | US | 2004007052 A1 | 15-01-2004 |
| US 5781764 | A | 14-07-1998 | NONE | | |
| US 2002180611 | A1 | 05-12-2002 | US | 6424266 B1 | 23-07-2002 |
| US 6609079 | B1 | 19-08-2003 | AT | 407206 B | 25-01-2001 |
| | | | AT | 82898 A | 15-05-2000 |
| | | | WO | 9960682 A1 | 25-11-1999 |
| | | | CA | 2331565 A1 | 25-11-1999 |
| | | | EP | 1078433 A1 | 28-02-2001 |
| US 5838881 | A | 17-11-1998 | NONE | | |

EPO FORM P0459

# EP 1 786 083 A1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **W. H. HAGMAN ; T. H. CROWLEY ; R. D. TABORS ; F. C. SCHWEPPES.** An adaptive transformer monitoring system. *Proceedings of the International Symposium for Demonstrations of Expert System Applications to the Power Industry,* 07 May 1989